# EUROPEAN PATENT APPLICATION

(11) **EP 1 555 676 A2**
(43) Date of publication of application: **20.07.2005**
(21) Application number: 05075053.8
(22) Date of filing: 10.01.2005
(51) Int. Cl.: G12B 21/20, G12B 21/02

(54) **Method of operating a probe microscope**

(30) Priority: 14.01.2004 US 536360 P; 23.04.2004 US 564852 P
(71) Applicant: FEI Company, Hillsboro, Oregon 97124-5793 (US)
(72) Inventor: Kneedler, Eric, Portland (OR) 97229 (US); Linder, Robert, Tigard (OR) 97422 (US); Vasilyev, Leonid, Beaverton (OR) 97007 (US); Berghaus, Andreas, Berlin 10783 (DE); Bryson, Charles E., III, Morgan Hill (CA) 95037 (US)
(74) Representative: Bakker, Hendrik

(57) **Abstract**

A method of improving the precision and speed of probe microscopy. Direct geometric measurement of relevant date points allows more rapid determination of critical dimensions while improving measurement precision through minimized system drift. Precision and throughput is further improved by deflection-based measurement. Sensitivity to soft contacts is improved by using diagonal approach trajectories for the probe tip (20). And throughput is improved while risk of damage to tip and/or surface is reduced by using lateral force detection.

## Description

### Technical Field of the Invention

The present invention relates to the field of probe microscopy and, in particular, to improved methods of critical dimension metrology using probe microscopes.

### Background and Summary of the Invention

The fabrication of advanced integrated circuits requires the formation of extremely small, precise features on a semiconductor wafer. Such features are typically formed first by a photolithography process in temporary layers of photoresist, and the photoresist features are then used to create permanent structures on the wafer. For example, holes are formed in insulating layers and later filled with a conductive material to create connections between layers in a circuit. Trenches are also formed in insulating layers and later filled with a conductive material to form capacitors. Groups of thin conductive lines are formed to make buses to carry signals from one area of a chip to another. The groups of conductors are characterized by the width of each conductor and a pitch, that is, the distance between the conductors.

As the precision requirements for semiconductor processing increases, there is a need to constantly monitor the fabrication process to ensure that it is meeting the stringent requirements. In some cases, every wafer going through the fabrication line is measured in what is sometimes referred to as in-line metrology. Engineers may monitor both the features on the temporary photoresist layer and the permanent features created on the wafer. Features on the wafer are three-dimensional structures and a complete characterization must describe not just a surface dimension, such as the top width of a hole or conductor, but a complete three-dimensional profile of the feature. For example, although an ideal feature typically has vertical sidewalls, the actual sidewalls may have excessive slope that narrows or widens the feature below its top surface. Process engineers must be able to accurately measure the critical dimensions (CD) of such surface features to fine tune the fabrication process and assure a desired device geometry is obtained.

Increasingly, manufacturers are turning to metrology tools such as probe microscopy, which uses the interaction of a very small probe tip with sample surfaces to allow 3-D imaging of surfaces with sub-nanometer resolution. One type of probe microscope is commonly referred to as a scanning probe microscope (SPM). A SPM uses a very small probe tip that is scanned across the surface of a substrate. A piezoelectric scanner (capable of extremely fine movements) typically is used as a positioning stage to accurately position the probe tip over the sample. The scanner moves the probe tip across the first line of the scan, and back. It then steps in the perpendicular direction to the second scan line, moves across it and back, then to the third line, and so forth.

As the scanner moves the probe tip along a scan line, the SPM collects data concerning the surface of the sample at equally spaced intervals. The spacing between the data points is called the step size or pixel size. The accuracy of the scan can be increased by using a smaller pixel size (which results in a greater number of data points, also referred to as pixel density). However, scans using a greater pixel density take longer to complete and require more resources to store and process.

There are many types of SPMs, including several types of atomic force microscopes (AFM). An SPM can operate in two different modes―contact mode or non-contact mode. In contact mode, the tip comes into physical contact with the sample surface. In non-contact mode, the tip does not actually touch the sample surface. Instead, the tip is in close proximity to the sample surface and interactive forces between the tip and the surface are measured.

In one type of AFM used in semiconductor processing, the probe tip is attached to a cantilever that is in turn attached to a piezoelectric actuator. The vibration amplitude of the cantilever driven near resonance frequency is monitored by reflecting a laser beam off the back surface of the cantilever into a photodiode sensor. Changes in the vibration amplitude of the cantilever cause changes in the readout signal of the optical sensor at the same frequency. The amplitude is sensitive to changes in tip-sample interaction, usually a result of distance change between tip and sample. The actuator maintains a level of tip-sample interaction.
The tip moves up and down in response to peaks and valleys on the sample surface. The vertical positions at or near contact are tabulated and provide a profile of the surface.

Cantilever-based AFM instruments suffer from a number of shortcomings that limit their usefulness for mass-production CD metrology applications. Contact-mode AFMs, especially those where the probe tip remains in constant contact with the sample surface, are prone to tip wear and the gradual buildup of contamination from the sample onto the probe tip. Non-contact AFMs do not have a problem with tip wear, however, they are much more vulnerable to error caused by localized charges, humidity, or even particulate contamination. Both types of cantilever-based AFMs also have the potential for tip or sample damage because the tip has to stay so close to the sample surface. Even more significant, both types of cantilever-based AFMs suffer from low throughput. When operated at a sufficient resolution to accurately measure current critical dimensions, it can take several minutes to make measurements across one feature and several hours to measure a 50 µm square area. For these reasons, prior art AFMs in a production operation can profile only a limited area on a semiconductor chip.

Another type of probe microscope is the Stylus NanoProfilometer (SNP), which is commercially available from FEI Company, Hillsboro, Oregon, the assignee of the present application. In contrast to the cantilever systems, the SNP makes use of a probe tip attached to a rocking balance beam, similar to those disclosed in U.S. Patent 5,307,693, to Griffith et al. for "Force-Sensing System, Including a Magnetically Mounted Rocking Element" and in U.S. Patent 5,756,887 to Bryson et al. for "Mechanism for Changing a Probe Balance Beam in a Scanning Probe Microscope." Recently developed probe tips have a cylindrically or approximately square shaped cross sections of dimensions of 0.2 µm or less. Such a small probe tip is usually relatively short, on the order of a micrometer, and is supported on its proximal end by a more massive tip support.

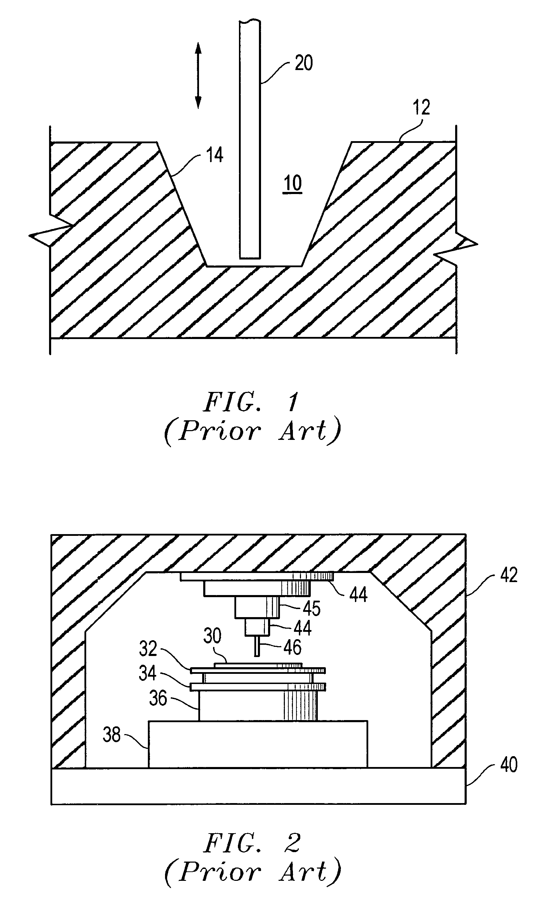

A typical probe tip is schematically illustrated in FIG. 1. During operation of the SNP, the probe tip 20 is discontinuously moved horizontally along a line. At multiple positions, which are typically periodically spaced, the horizontal movement of the probe tip 20 is stopped, and it is gently lowered until it is stopped by the substrate surface 12. Circuitry to be briefly described later measures the height at which the probe tip stops. The SNP probe tip 20 is then retracted from the surface 12 a distance sufficient to clear any vertical features, moved horizontally a preset distance, and then moved vertically back toward the surface 12. A series of such measurements around the feature being probed, for example, on either side of and within the trench 10, provides a profile or topography of the sample.

A prior-art SNP is schematically illustrated in the side view of FIG. 2. A substrate 30 or other sample to be examined is supported on a support surface 32 supported successively on a tilt stage 34, an x-slide 36, and a y-slide 38, all of which are movable along their respective axes so as to provide horizontal two-dimensional and tilt control of the substrate 30. The tilt stage is also capable of 10mm or more of vertical Z travel. Although these mechanical stages provide a relatively great range of motion, their resolutions are relatively coarse compared to the resolution sought in the probing. The bottom y-slide 38 rests on a heavy granite slab 40 providing vibrational stability. A gantry 42 is supported on the granite slab 40. A probe head 44 hangs in the vertical z-direction from the gantry 42 through an intermediate piezoelectric actuator 45 that provides about 30 µm of motion in x and y and 15 µm in z by way of a piezo driven 3-axis flexure system 46 controlled by linearized capacitors in closed loop. Probe head 44 includes a small attached probe tip 20 that projects downwardly from the probe head 44 so that probe tip 20 can selectively engage with the top surface of the substrate 30 and thereby determine its vertical and horizontal dimensions.

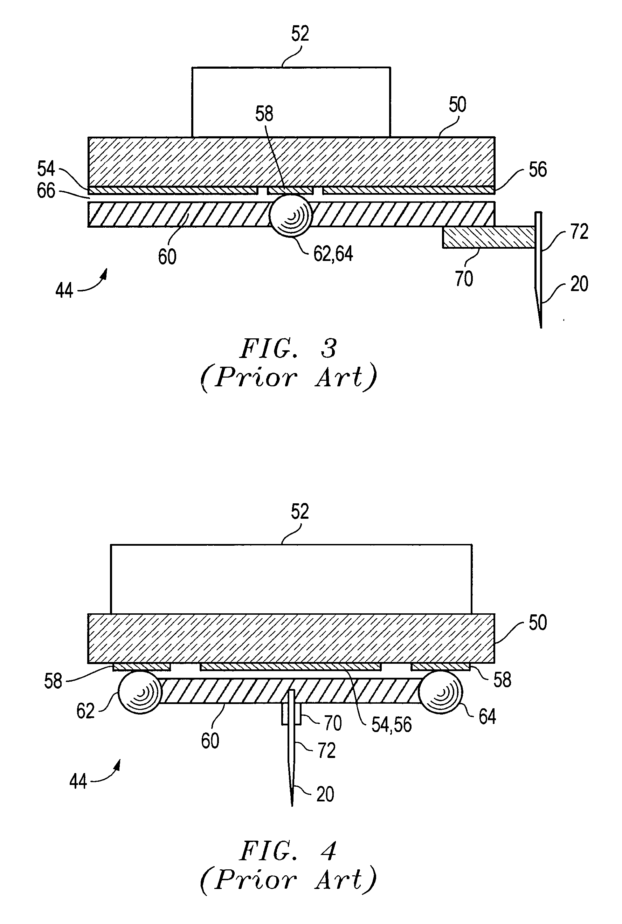

Principal parts of the probe head 44 of FIG. 2 are illustrated in the side views of FIGS. 3 and 4. A dielectric support 50 fixed to the bottom of the piezoelectric actuator 45 includes on its top side, with respect to the view of FIG. 2, a magnet 52. On the bottom of the dielectric support 50 are deposited two isolated capacitor plates 54, 56 and two interconnected contact pads 58. A conductive beam 60 is medially fixed on its two lateral sides and electrically connected to two metallic and ferromagnetic ball bearings 62, 64. Ball bearings 62, 64 are placed on the contact pads 58 and generally between the capacitor plates 54, 56, and held in place by magnet 52.

Beam 60 is held in a position generally parallel to the dielectric support 50 with a balanced vertical gap 66 of about 25 µm between the capacitor plates 54, 56 and the beam 60. Two capacitors are formed between the respective capacitor pads 54, 56 and the conductive beam 60. Capacitor pads 54, 56 and contact pads 58, all electrically connected to the conductive beam 60, are also connected to three terminals of external measurement and control circuitry to be described later. Beam 60 holds on its distal end a glass tab 70 to which is fixed a stylus 72 having a probe tip 20 projecting downwardly to selectively engage the top of the substrate 30 being probed. An unillustrated dummy stylus or substitute weight on the other end of the beam 60 can provide rough mechanical balancing of the beam in the neutral position.

The typical SNP operates through the use of a force-balance system, so that externally applied force (such as the force generated when the probe tip encounters a feature) acts on a sensing device, the output of which produces a locally generated counteracting force to drive the sensor output back to zero. Capacitor plates 54, 56 and the two contact pads 58 are separately connected by three unillustrated electrical lines to three terminals of external measurement and control circuitry. This servo system both measures the two capacitances and applies differential voltage to the two capacitor plates 54, 56 to keep them in the balanced position. When the piezoelectric actuator 45 lowers the stylus 72 to the point that probe tip 20 encounters the surface of the feature being probed, the beam 60 rocks upon the contact of probe tip 20 with the substrate 30. The difference in capacitance between the plates 54, 56 is detected, and the servo circuit attempts to rebalance the beam 60 by applying different voltages across the two capacitors.

Two different feedback loops are thus at work during the operation of the SNP. When the probe head 44 is lowered until the probe tip 20 touches the substrate surface 30, the balance beam 60 will typically be knocked a little off balance. The dual feedback system works to adjust the vertical position of the tip 20 by way of the piezoelectric actuator 45 and to bring the beam 60 back into balance by applying different voltages across the two capacitors. Whenever the force acting on the probe tip 20(measured by the voltage applied in order to balance the beam) is below a certain force set point, the piezoelectric actuator 45 will lower the probe head. If the force acting on the probe tip 20 is above the force set point, the piezoelectric actuator 45 will raise the probe head 44. When the two feedback loops reach equilibrium, the force acting on the probe tip 20 will be at the force set point and the beam 60 will be returned to a balanced state. When this occurs, the vertical position of the piezoelectric actuator 45 can be used as an indication of the depth or height of the feature at the particular data point being measured.

A SNP, such as the one discussed above, addresses some of the shortcomings of cantilever-based probe microscopes, namely the constantly changing geometrical relationship between the tip and the sample, tip wear from continuous scanning, gradual buildup of contamination, and constantly varying tip-to-sample geometry. However, prior-art SNPs also suffer from a number of drawbacks that limit their use for mass-production applications.

First, as is the case for cantilever-based AFMs, SNP throughput when using the prior art scanning technique is low due to its slow imaging rate. It takes a relatively large amount of time to profile a data point with an SNP. In order to avoid accidentally damaging the probe tip, the tip must be lowered to the substrate surface very slowly and must be raised to a significant height above the substrate before it can be moved to the next data point. Once the probe tip makes contact with the substrate surface, the beam must be balanced and the competing feedback loops must equilibrate before accurate data can be collected.

Further, a prior art SNP requires a large number of data points to adequately profile a feature. As discussed above, the area around a feature is usually scanned using a stepped pattern of scan lines. Typically, an area 1 to 2 microns square would be profiled using from 5 to 100 scan lines, with between 200 and 400 data points used along each scan line

The large amount of time required to profile a feature also leads to problems with system drift. Drift in the position of the scanner can be caused by temperature variations or by stresses in the scanner and its mounting hardware. Whatever the source of the drift, it will typically tend to worsen with time. As a result, the longer it takes to complete the analysis of an area, the more system drift will be present.

Prior art SNPs also have difficulty with "soft" contacts such as the contact between a probe tip and a nearly vertical sidewall. As discussed above, when a probe tip moving vertically downward encounters a planar surface, the upward force on the tip will increase very rapidly with continuing downward movement of the probe tip, and the SNP's force set point will be quickly reached. The situation is somewhat different when a probe tip moving vertically downward encounters a sharply sloped surface, such as a nearly vertical sidewall. Because of the angle between the tip and the sloped surface, the tip will tend to slide down the surface well past the original contact point.

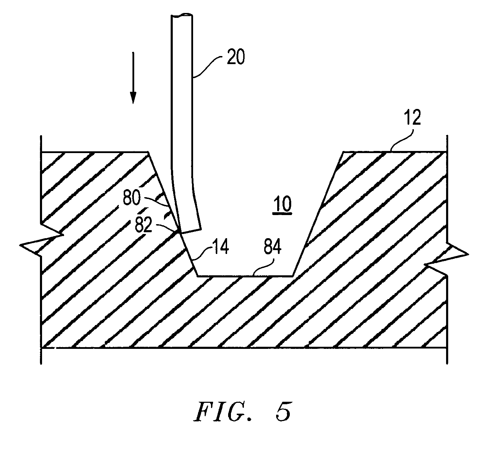

As illustrated schematically in FIG. 5, when a narrow probe tip 20 encounters the sloping sidewall 14, the probe tip 20 may physically encounter the sloping sidewall 14 at a point 80; but, because the probe tip 20 is relatively flexible in the lateral direction, the oblique force exerted on it causes it to bend with the slope of the wall 14 as the tip is further lowered. Other portions of the apparatus may also move in reaction to the lateral force imparted by the sloping sidewall 14. As a result, the force encountered after initial contact does not increase as quickly as if the encountered surface were planar. The threshold thus may not be exceeded until the probe tip is lowered to a point 82 significantly lower down the sidewall 14. This results in a false measurement of the depth of the sidewall 80 at the original horizontal position of the probe tip 20, or alternatively a false measurement of the horizontal position for such a sidewall depth.

And finally, because the probe tip of a prior-art SNP only moves toward the substrate surface in a purely vertical direction, SNPs cannot be used to profile completely vertical walls or undercut features.

Therefore, there is a need for an improved technique to allow rapid and accurate CD metrology using probe microscopes.

### Summary of the Invention

An object of the invention, therefore, is to allow rapid and accurate probe metrology suitable for mass-production applications. Preferred embodiments of the invention described and claimed herein comprise the use of any combination of direct measurement of relevant feature data points, deflection-based scanning, diagonal probe tip approach trajectories, and lateral-force detection to accomplish this goal.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims.

### Brief Description of the Drawings

For a more complete understanding of the present invention, and the advantages thereof, reference is now made to the following descriptions taken in conjunction with the accompanying drawings, in which:

FIG 1 is a schematic cross-sectional view of a typical probe tip profiling a feature on a substrate.

FIG. 2 is a side view of a prior art probe microscope.

FIG. 3 is a side view of the probe head of FIG. 2.

FIG. 4 is an end view of the probe head of FIG. 2.

FIG. 5 is a schematic cross-sectional view of the probe tip of FIG. 1 profiling a sloping sidewall.

FIG. 6A is a schematic representation of a cross-section of a substrate feature showing the location of coarse positioning data points according to the present invention.

FIG. 6B is a schematic representation of a cross-section of a substrate feature showing the location of relevant data points for calculating the depth of the feature according to the present invention.

FIG. 6C is a schematic representation of a cross-section of a substrate feature showing the desired depth for a critical dimension measurement according to the present invention.

FIG. 6D is a schematic representation of a cross-section of a substrate feature showing the showing the location of relevant data points for calculating the critical dimension measurement according to the present invention.

FIG. 7A is a graphical representation of the voltage differential using prior art force-balance measurement for a typical data point.

FIG. 7B is a graphical representation of the vertical position of the piezoelectric actuator over the time period of FIG. 7A.

FIG. 7C is a graphical representation of the beam deflection as a function of time and of the output of a statistical manipulation of beam deflection data for the same typical data point shown by FIGS. 7A and 7B.

FIG. 7D is a graphical representation of the vertical position of the piezoelectric actuator over the time period of FIG. 7C.

FIG. 8A is a schematic representation of a cross-section of a prior art probe tip 20 lowered vertically toward a steep sidewall.

FIG. 8B is a schematic representation of a cross-section of a probe tip lowered diagonally toward the same sidewall according to the present invention.

FIG. 9 is a graphical representation of the force exerted against the probe tip as a function of time for the vertical approach trajectory of FIG. 8A and the diagonal approach trajectory of FIG. 8B.

FIG. 10 shows schematically a cross-section of a vertical feature and illustrates a method of lateral force detection and minimal z-retraction according to the present invention.

### Detailed Description of Preferred Embodiments

Preferred embodiments of the present invention are directed to improved methods of metrology using probe microscopes. Although much of the following description is directed toward a Stylus NanoProfilometer (SNP) that makes use of a probe tip attached to a rocking balance beam, the methods of the present invention could equally be utilized with any type of probe microscope.

A preferred method of the present invention has many novel aspects, and because the invention can be embodied in different methods for different purposes, not every aspect need be present in every embodiment. Moreover, many of the aspects of the described embodiments may be separately patentable.

As discussed above, prior art SPMs typically scan an entire line by collecting data points along the line at equally spaced intervals called pixels. In this Application, "data point" will be used to refer to a particular x-y-z coordinate, rather than an x-y coordinate alone. Skilled persons will recognize that for undercut or vertical features, there may be a number of different z values at a given x-y coordinate.

In accordance with one aspect of a preferred embodiment, the present invention derives significant advantages from a method of limiting data points to those most relevant to the desired measurement. According to a preferred embodiment, an adaptive algorithm is used to locate the relevant points of measurement on a known feature of interest, for example a trench with an expected topographical profile (such as depth, width, or slope) formed at known x-y coordinates on a semiconductor substrate during fabrication. Instead of profiling the feature by measuring at each of the successive data points along a scan line, the SPM probe tip can hop directly between relevant data points

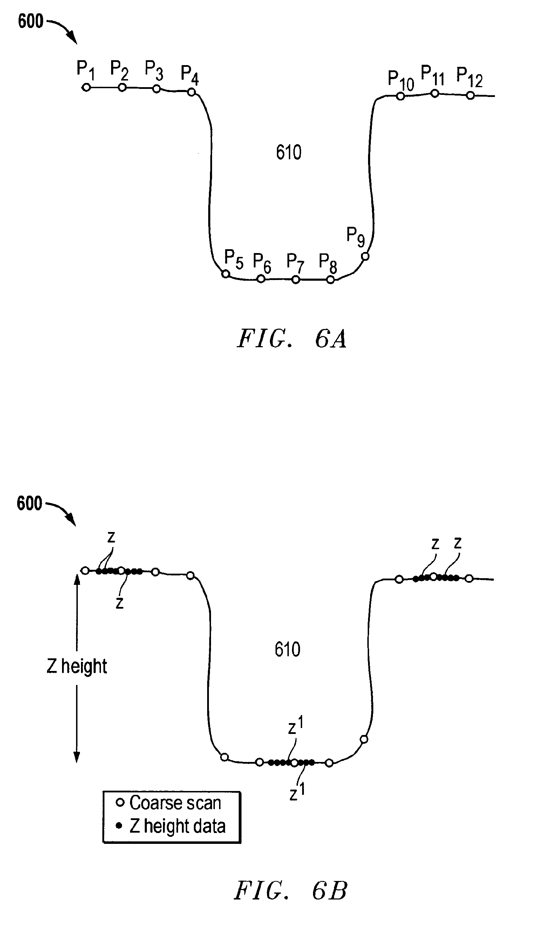

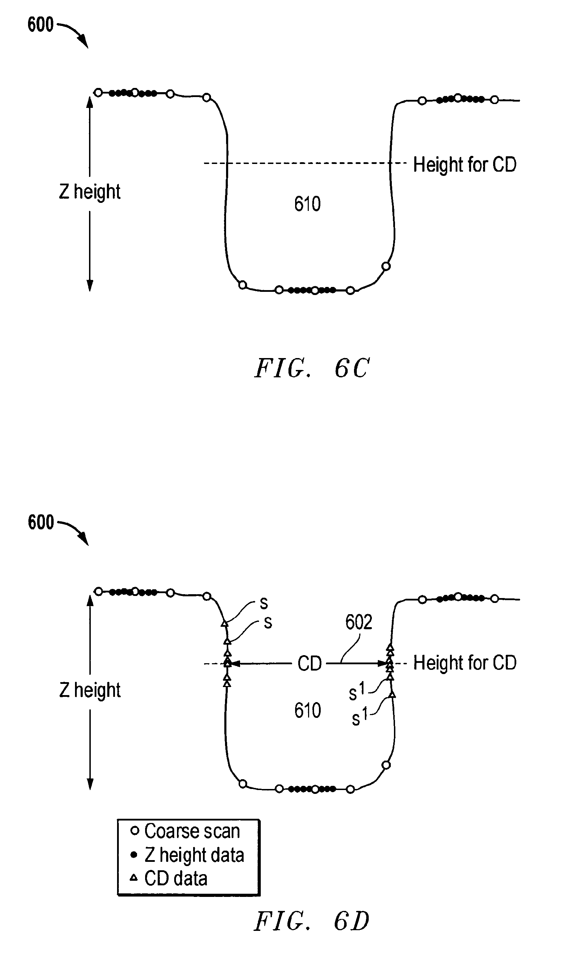

In a preferred embodiment, the present invention utilizes an adaptive algorithm to locate the relevant points of measurement for a particular feature. The SMP probe tip can then be moved directly between the relevant points. According to this embodiment of the invention, the SNP can navigate to the approximate x-y coordinates of a feature using methods well known in the prior art, including for example optical pattern recognition. Once the approximate coordinates are reached, a few coarse positioning data points are used to more accurately locate the feature. This process is illustrated in FIGS. 6A-6D, which are schematic representations 600 of a cross-section of a trench formed in a semiconductor substrate.

In a preferred embodiment, an adaptive algorithm utilizes the expected location and dimensions of the feature to select positioning data points P₁ through P₁₂, which are used to roughly locate the expected feature, such as trench 601. After that, the algorithm can select a number of data points at relevant locations to be measured. For example, in order to determine the depth of trench 601, a number of data points Z on either side of the trench and a number of data points Z' along the bottom of the trench can be measured. The depth (Z height) of the trench 601 can then be easily determined without measuring every pixel along a scan line. Measuring data points along the top of the trench and then moving directly to measure data points on the bottom of the trench (without having to profile the sidewalls) allows for a much faster analysis. As discussed in greater detail below, a faster analysis will allow less time for drift or creep to occur.

This method of measuring only relevant data points can also be used to determine other critical dimensions (CD) such as feature width. In order to then determine the width of the trench , a number of data points S on the right sidewall and data points S' along the left sidewall can be measured. Typically, in order to measure a CD such as trench width, the width would be measured at a specified depth 602 (or a specified height for a feature such as a conductive line). The specified height or depth can be specified either as an absolute value or as a percentage of overall feature height or depth. According to the present invention, once the feature has been roughly located, the probe tip can be jumped back and forth between opposite sidewalls near the specified height in order to make the CD measurement.

Typically, some of the data points measured will be above the desired height and some below. Skilled persons will recognize that some degree of "scatter" (data points above and below the specified depth) is often desirable because it allows for more accurate measurement of rough sidewalls. Further, as is known in the art, accurate AFM measurement often requires that the effects of tip geometry be taken into account by subtracting the tip from the original image through a mathematical operation known as erosion or deconvolution. A scattering of points slightly above and slightly below the specified height makes it more likely that the erosion corrected data points will include data at the specified height. In a preferred embodiment, an adaptive algorithm will be able to measure an appropriate number of data points above and below the specified height. After the data is corrected for tip shape, these data points can be used, typically by way of a least squares analysis, to determine the width of the feature.

If, for example, the expected topography of the feature is a trench with sloping sidewall so that the bottom is narrower than the top, and the first data point hits slightly above the specified height for the CD measurement, the algorithm will preferably adjust the next data point so that it is slightly more toward the center of the trench (since that data point would be expected to be slightly lower than the previous data point). Each data point will not necessarily be closer to the specified height than the one before due to unpredictable variations in topography or the possibility of overshooting the data point. However, a relatively small number of data points (as compared to prior art SPMs) will preferably be sufficient to zero in on the desired measurement.

This embodiment of the present invention provides a number of advantages over the prior art. Preferably, only 10-20 data points will be needed to roughly locate the feature, and another 20-40 data points to determine the critical dimensions of the feature. As discussed above, prior art SNPs typically use 200-400 data points per scan line. Since fewer data points are actually measured, throughput can be greatly increased. Further, in general, a faster analysis will allow less time for drift or creep to occur. Preferably, the sidewall data points will be measured alternatively (a point on one wall followed by a point on the other). In that event, measuring relative points on each of the sidewalls can occur on the order of 10 to 100 times faster than the prior art method of scanning along the entire line. This greatly reduces the amount of drift or creep and serves to increase the precision and accuracy of the CD measurement. Because multiple scan lines are used in part to overcome precision issues such as system drift, for some applications faster measurement of data points may also reduce the total number of scan lines required to profile a feature.

Although this embodiment of the present invention could equally be utilized with any type of probe microscope, this aspect of the invention is particularly well suited to use with a SNP. This is because SNPs are designed to have the probe tip leave the feature between pixels, as opposed to cantilever-based AFMs which are designed to have the probe tip closely follow the profile of the feature.

Precision and throughput can be further improved by using deflection-based measurement, rather than the force-balance measurement known in the prior art. As discussed above, prior art SNPs collect each data point in a profile by measuring the probe position while the tip pushes into the surface with a prescribed force. When the probe head is lowered to the point that probe tip encounters the surface of the feature being probed, the beam will be momentarily unbalanced. A difference in capacitance between the plates is detected, indicating the deflection of the beam. The servo circuit then attempts to rebalance the beam by differential voltage to the two capacitor plates. That voltage differential is proportional to the force exerted against the probe tip by the surface of the substrate. Force-balance measurement was intended to minimize profiling distortions by providing for consistent tip-sample deformation from one pixel to another. Unfortunately, highly varying topography, narrow flexible tips, and difficult sensor equilibration render the force-balance method vulnerable to significant distortions anyway.

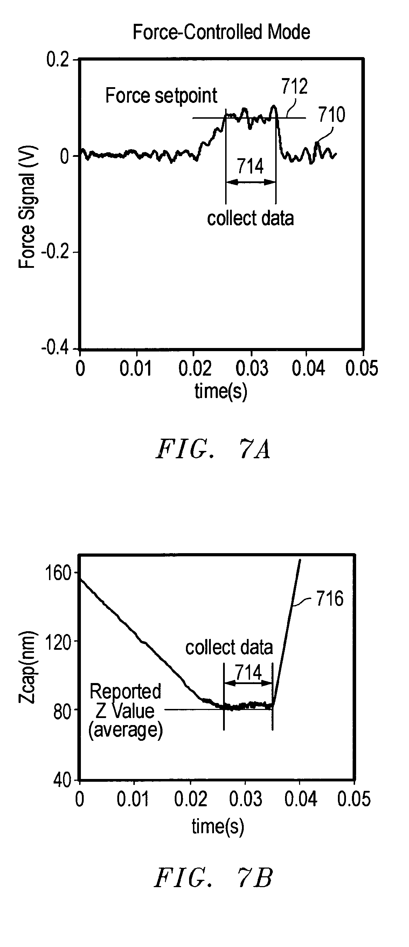

A graphical representation of the voltage differential using force-balance measurement for a typical data point is shown by FIG. 7A. Line 710 shows the force exerted against the probe tip as a function of time. As shown by the graph, the force values for 0 to 0.02 seconds is approximately 0.4 volts. The values during this timeframe show the baseline, in other words the force when the tip is being lowered to the surface. Beginning shortly after 0.02 seconds, the curve begins to rise until it reaches the force set point, shown by horizontal line 712, indicating that the tip is in contact with the surface. The tip remains in contact with the surface for a time interval 714. The force values then gradually return to baseline, indicating that the tip has left the surface.

FIG. 7B is a graphical representation of the vertical position of the piezoelectric actuator shown by line 716 over a time period identical to FIG. 7A. As indicated by the force data shown in 7A, time interval 714 represents the period of time when the probe tip is on the surface. Vertical position data for time period 714 can be averaged as shown by horizontal line 715 to provide a value for this particular data point.

In accordance with another aspect of a preferred embodiment, the deflection-based measurement taught by the present invention identifies the location of a surface by simultaneously measuring probe position and the signal representing the deflection in the balance beam during the approach of the probe tip to the surface. The point of impact is identified by an abrupt change in balance signal, rather than using the force set point taught by the prior art. Fast statistical analysis can be used to pinpoint the exact probe tip position at point of impact. Response to contact is thus governed by sensor bandwidth, and decoupled from the limited physical response of the force sensor. This decoupling provides significant advantage by permitting a soft physical contact as defined by the physical properties of the balance beam while at the same time having a high-bandwidth knowledge of the balance beam's position.

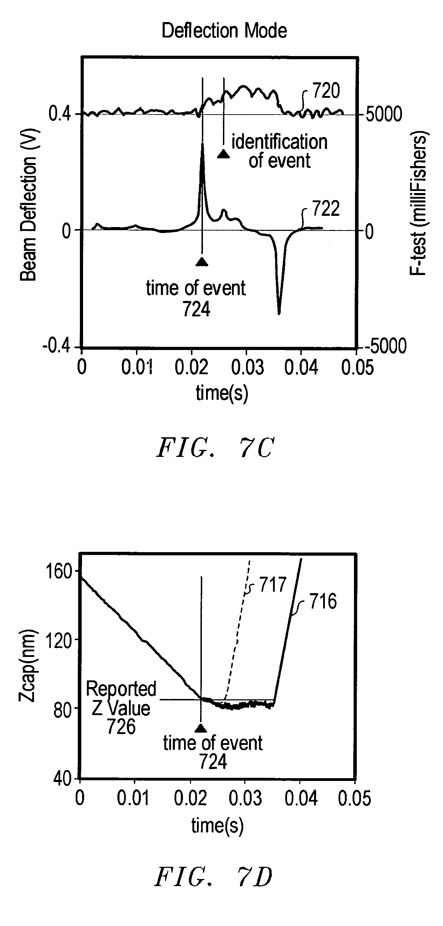

Referring to FIG. 7C, line 720 shows the beam deflection as a function of time for the same typical data point shown by FIGS. 7A and 7B. According to the present invention, the beam deflection data can be processed using a statistical manipulation known as an F-test, which compares two populations and determines how different they are from each other. Here, using a circular buffer, the trailing baseline signal is compared to the leading deflection signal to determine when the deviation from baseline becomes significant. Line 722 shows the statistical output using the same time scale as used for line 720. The statistical output indicates that the most significant difference between baseline and signal occurs at time of event 724. The sharp peak in line 720 occurring at time of event 724 is an indication of the point of impact between the probe tip and the substrate surface.

FIG. 7D is the same graphical representation of the vertical position of the piezoelectric actuator 716, as shown in FIG. 7B, over a time period identical to FIG. 7C. As shown by FIG. 7D, the intersection of line 716 (indicating probe position) and time of event 724 (determined by statistical analysis of the deflection signal) is used to provide a value for the data point, shown on the graph as reported z value 726.

Alternatively, the force data shown in FIG. 7A could be subjected to the same kind of statistical manipulation to determine when the deviation from baseline on the force curve becomes significant. A graph of the output of such a statistical manipulation of the force curve data would show a sharp peak indicating time of impact, similar to the peak seen on line 720 in FIG. 7C. However, because the force data is generated by passing the deflection data through a PI circuit, using force data for this kind of statistical analysis would be slower and less direct.

Skilled persons will recognize that using a deflection-mode analysis as taught by the present invention can result in a significant reduction in the time required to measure a data point. Because equilibration isn't necessary, the probe tip does not have to remain in contact with the substrate surface for the extended period shown in FIGS. 7B and 7D. Instead, the probe tip can be withdrawn from the substrate surface almost immediately, as shown by line 717 in FIG. 7D.

In addition to allowing reduced measurement time, using a deflection-mode analysis as taught by the present invention also results in increased sensitivity and precision for soft contacts, such as data points along nearly vertical sidewalls. As discussed above, the force-balance system of the prior art requires the force exerted on the probe tip by the sample reach a certain set point before the horizontal position is determined. Where a steep sidewall is being profiled, profile distortions such as tip flex and slippage can degrade measurement precision and accuracy. Because deflection-mode analysis as taught by the present invention identifies the initial impact between probe tip and surface, subsequent tip flex or slippage will not affect measurement of either depth or horizontal position.

In accordance with another aspect of a preferred embodiment of the present invention, sensitivity to soft contacts can be increased still further by having the probe tip approach the substrate surface along a diagonal approach, rather that the purely vertical approach found in the prior art. As discussed above, in prior art SNPs, the probe tip moves toward the substrate surface in a purely vertical direction. Typically, the sample is loaded into a prior art SNP so that the sample surface (as a whole) is perpendicular to the z-axis of the scanner. The tip is positioned over a particular pixel and then gently lowered until it is stopped by the substrate surface. The tip is then retracted from the surface to a distance sufficient to clear any vertical features, moved horizontally a preset distance, and then moved vertically back toward the surface.

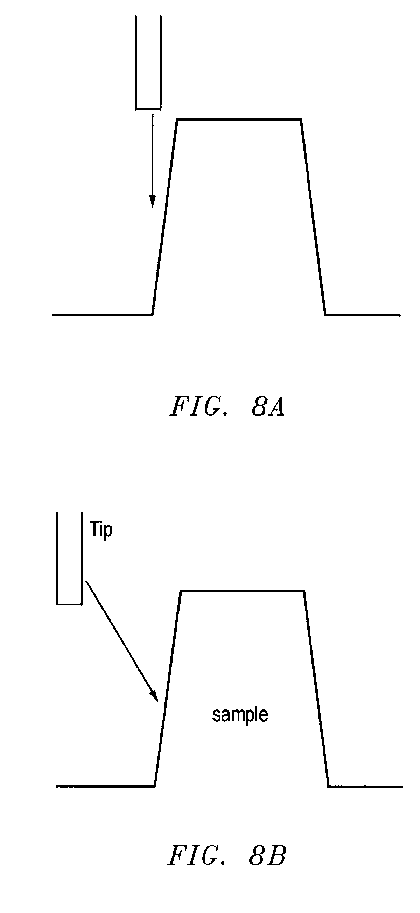

Unfortunately, as also discussed above, problems arise when prior art SNPs attempt to profile steep sidewalls. FIG. 8A schematically illustrates a typical prior art probe tip 20 lowered vertically toward a steep sidewall 14. If probe tip 20 vertically impacts a sidewall 14, the vertical component of the force (what an SNP measures) is relatively small until slippage builds up enough strain and friction. Because the typical probe tip is also somewhat flexible in the lateral direction, the oblique force exerted on it by contact with the angled surface can cause it to bend with the slope of the wall as the tip is further lowered. As a result, the vertical force encountered after initial contact does not increase as quickly as if the encountered surface were planar. The force set point thus may not be exceeded until the probe tip 20 is lowered to a point significantly lower down the sidewall from the original point of contact, which can result in significant measurement error.

In order to address this problem, a method of operating a SNP according to the present invention can use a diagonal approach to the substrate surface. FIG. 8B schematically illustrates a probe tip 20 lowered according to this aspect of the present invention. The probe tip 20 not only moves vertically as taught by the prior art, but will simultaneously move in a lateral direction resulting in a diagonal approach toward sidewall 14. In a preferred embodiment, the angle of the approach should be at or nearly perpendicular to the localized surface angle. With a diagonal trajectory, both strain and friction are established much more quickly, making it easier to detect vertical force and prevent slippage. Skilled persons will recognize that an SNP according to the present invention could have difficulty detecting a purely lateral force because such a force may not unbalance the SNP's rocking balance beam. As a result, for very steep sidewalls (approaching 90 degrees) it will be preferable to move the probe tip at a trajectory that is less than perpendicular to the sample surface so that a vertical force component will be present.
In any event, even for very steep sidewalls, the approach angle will preferably be at angle of approximately 30 to 60 degrees in order to avoid a grazing contact with the sidewall. Most preferably, the approach angle for a very steep sidewall will be approximately 45 degrees.

In a preferred embodiment, an adaptive algorithm can be used to predict the approximate surface angle for each data point of a known feature of interest, for example a trench with an expected topographical profile. Alternatively, the measurement values of previous data points can be used to calculate the approximate surface slope for successive data points.

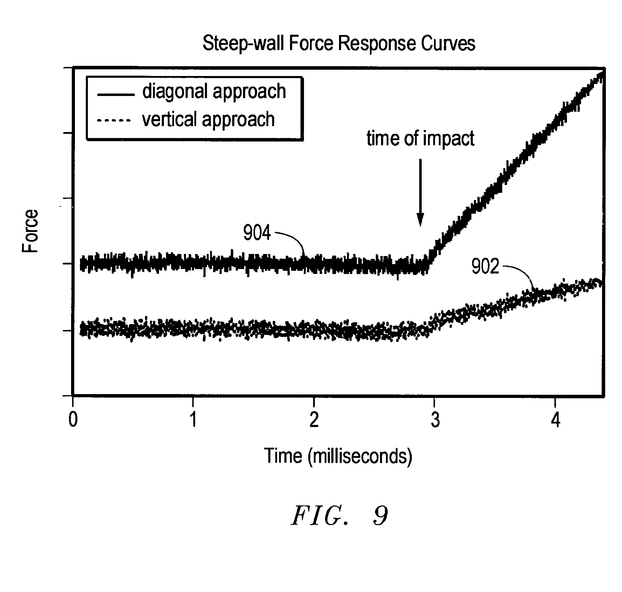

FIG. 9 is a graphical representation of the force exerted against the probe tip as a function of time for two different approach vectors toward a soft contact (such as a steep sidewall). Line 902 shows the force values resulting from a purely vertical approach vector. Line 904 shows the force values resulting from a diagonal approach vector according to the present invention. As shown by FIG. 9, a diagonal approach trajectory results in a much sharper climb in the force curve after the tip impacts the sidewall surface.

In accordance with this aspect of a preferred embodiment of the invention, an accurate lateral position sensor can be utilized to keep track of the probe tip's continuously changing lateral component. Preferably, the scanner will have sufficient lateral response to prevent any undesired lateral motion.

A prior-art SNP does not have the ability to profile completely vertical sidewalls or undercut features. However, the characterization of reentrant structures is key for today's advanced masks. The lateral motion component of the diagonal approach trajectory makes it possible to use an SNP to profile these types of structures. A standard cylindrical probe tip could be used to profile a vertical sidewall using a diagonal approach trajectory. Re-entrant profiles would require both some degree of lateral movement and a boot-shaped probe tip in order to access data points under an overhanging roof. As discussed in greater detail below, a preferred embodiment of the present invention would use a vertical contact sensor to detect non-vertical (lateral) impacts. In some circumstances, such a vertical contact sensor could even be used to detect purely lateral impacts. This would allow accurate profiling of vertical and re-entrant structures.

In accordance with one aspect of a preferred embodiment of the invention, a method of lateral force detection is employed to prevent tip damage from an unexpected lateral contact. As discussed above, a prior-art SNP only detects vertical forces. As a result, in order to avoid tip and/or sample damage, the tip must be raised to a significant height above the substrate to ensure that the tip is clear of all vertical features before it can be moved to a new data point. For each data point measured, a substantial amount of time is spent slowly lowering the tip from a relatively great distance above the surface and then raising the tip back up to that relatively great distance before moving to the next data point. If lateral contact could be detected before tip and/or sample damage occurred, then these types of large time-consuming hops would not be necessary. A preferred embodiment of the present invention allows high-aspect features, including re-entrant structures, to be navigated much more rapidly than the prior art (3-5x faster). The reduction in measurement time also improves precision by minimizing drift errors.

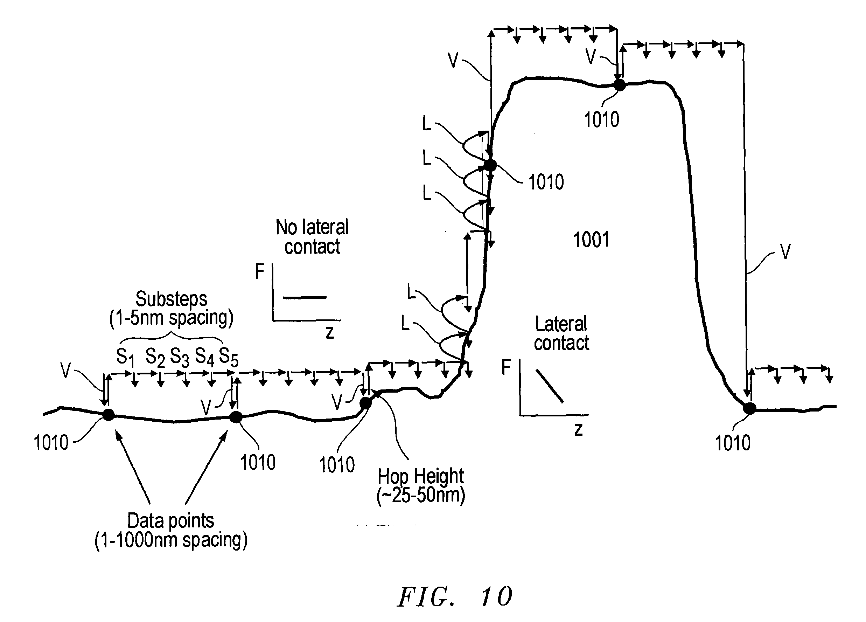

In accordance with one aspect of a preferred embodiment, the present invention makes use of an adaptive algorithm and a method of lateral force detection to detect sidewall contact. FIG. 10 shows schematically a cross-section of a vertical feature, in this case a cross-section of a conductive line 1001 on a semiconductor chip. At each data point 1010, the probe tip (not shown) is lowered to the surface along path V, contact is detected (using either the force-balance method of the prior art or the deflection control method of the present invention) and data is collected. Then the probe tip retracts slightly back up along path V, before beginning to move laterally toward the next data point. Rather than moving all the way to the next data point, the probe tip moves is smaller substeps S₁ to S₅, preferably of 1 to 5 nm. After each substep, the probe tip is modulated vertically down and up through a distance that is preferably about 2 to 10 nm. If the lateral substep brought the probe tip into contact with a sidewall, the modulation of the probe tip down and/or up will result in friction as the probe tip pushes against the sidewall. This friction will be registered as vertical force (again using either the force-balance method of the prior art or the deflection control method of the present invention). In this manner, vertical force can be used to detect lateral contact.

If lateral forces are detected, the probe tip backs up laterally and climbs higher before re-approaching the surface along path L. This step is repeated as necessary to clear the feature. If no lateral forces are detected, the probe tip continues with the next substep or the next data point. In this mode, the system dynamically adjusts to feature topography. The advantages of this mode include parameters that are independent of feature height and topography. No hop height or feature height settings are required. The risk of tip or sample damage is greatly reduced, while at the same time measurement speed is improved because the tip doesn't have to be moved far from the sample surface. As a result, it takes less time to move from line edge to line edge, and CD precision and throughput are improved. Another benefit is that any topography can be analyzed safely without the operator knowing the maximum feature height beforehand.

Although FIG. 10 illustrates a static version of this aspect of the present invention where the probe tip is either moved vertically or laterally, skilled persons will recognize that a dynamic version combining simultaneous lateral and vertical movement could also be used. In a dynamic version, the probe tip would effectively move through space in a triangle wave. A static approach would essentially have a resolution limited to the size of the lateral substeps. There would typically be some degree of overshoot for each lateral contact. Data would be more accurate using a dynamic "triangle approach" because a data point can be generated by the probe tip's initial contact with the wall, rather than at a set substep distance.

In accordance with another aspect of the present invention, the adaptive algorithm can also be used to prevent tip damage when profiling undercut structures. When a boot-shaped tip is used to profile an undercut structure, it is possible for the tip to be caught under the roof of the undercut structure. In this case, the algorithm must also recognize upward contact and back up multiple lateral steps as necessary. More generally, the tip must respond to contact in any direction in such a manner as to guarantee progress along the profile. The algorithm can also provide a means to identify lateral contact during downward progress on a feature by testing for lateral contact backward at intervals. In this way an overhung structure can be profiled in either direction.

Preferably, the algorithm will be also able to compensate for hysteresis effects of tip-sample interaction in order to prevent feedback loops. If, for example, when profiling a sidewall wall of an undercut structure using a boot-shaped tip, the tip is moving laterally and comes into contact with the wall. As discussed above, the probe tip would preferably be backed up and either raised or lowered (depending on the expected topography of the feature) and then re-approach the wall. Sometimes, however, there is a momentary attraction that holds the tip in contact with the sidewall so that when it finally releases the tip snaps back several steps from the sidewall (a hysteresis effect). If the probe tip moves a step forward and does not make a lateral contact, the normal algorithm would direct the tip to lower to the sample surface where it would soon begin climbing the same sidewall again. In order to prevent these types of infinite loops, the algorithm will preferably be able to recognize that the probe tip has already climbed the feature and even though there is no initial lateral contact when it moves back toward the wall, the tip needs to keep moving forward until it makes contact with the sidewall.

In some circumstances, purely lateral movement of the probe tip might be desirable, such as profiling the sidewalls of an undercut feature. Although possibly not as sensitive as the embodiment discussed above, in another preferred embodiment of the present invention, a probe tip moved in a purely horizontal direction can also be used to detect a lateral force. Referring again to Fig. 3, because the tip 20 is not located in the same plane as the pivot point for the balance beam 60, a purely lateral force exerted on the tip will tend to rock the balance beam. This property allows a deflection of the beam to be correctly interpreted as either a vertical or a lateral contact as long as the direction of tip movement is taken into account. In the prior art, a deflection of the balance beam is typically interpreted as a vertical contact or force. However, where the tip is being moved in a purely lateral direction, such a deflection will indicate a lateral force rather than a vertical force.

A preferred system of the present invention has many novel aspects, and because the invention can be embodied in different methods for different purposes, not every aspect need be present in every embodiment. Moreover, many of the aspects of the described embodiments may be separately patentable. The techniques and aspects of the present invention described herein can be used by themselves or in any possible combination.

For example, referring again to FIGS. 6A through 6D, according to a preferred embodiment of the present invention, an adaptive algorithm utilizes the expected location and dimensions of the feature to select positioning data points P₁ through P₁₂, which are used to roughly locate the expected feature, such as trench 601. The data points could be measured using the deflection control mode discussed above in order to improve throughput, precision, and sensitivity (especially on the sidewalls). Lateral-force detection could also be employed to move between data points in order to further improve throughput and reduce the risk of tip and/or sample damage resulting from unexpected variation in the feature.

After the feature is located, the algorithm can select a number of data points at relevant locations to be measured in order to measure the desired dimensions. In order to then determine the width of the trench (CD), a number of data points S on the right sidewall and data points S' along the left sidewall can be measured. Typically, in order to measure a CD such as trench width, the width would be measured at a specified depth 602. Once the feature has been roughly located, the probe tip can be jumped back and forth between opposite sidewalls near the specified height in order to make the CD measurement. Again, deflection mode and lateral-force detection can be employed to measure the relevant data points. For the data points on the trench sidewall, which will be used to determine the width (CD) of the feature, a diagonal approach trajectory can be used to increase sensitivity to soft contacts on the steep sidewalls. The combination of these aspects of the present invention can thus be expected to provide significant improvements in throughput, precision, and sensitivity over the prior art.

Although the present invention and its advantages have been described in detail, it should be understood that various changes, substitutions and alterations can be made to the embodiments described herein without departing from the spirit and scope of the invention as defined by the appended claims. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A method of determining at least one dimension of a feature on a sample, said feature having an expected topography and a known approximate location, the method comprising:
loading the sample into a probe microscope having a probe tip;
determining the number and location of a plurality of positioning data points sufficient to locate the feature;
measuring data related to a height of said sample at each positioning data point;
determining the location of the feature from the data related to a height of said sample at each positioning data point;
determining from the expected topography of the feature and the location of said feature the number and location of a plurality of relevant data points sufficient to determine at least one dimension of said feature;
measuring data related to a height of said sample at each relevant data point; and
determining said dimension of a feature from the value of the data related to a height of said sample at each relevant data point.

2. The method of claim 1 in which determining at least one dimension of a feature on a sample comprises determining the height, depth, width, or sidewall slope of the feature.

3. The method of claim 1 in which determining at least one dimension of a feature on a sample comprises determining the width of a feature at a specified height or depth on the sidewalls of the feature.

4. The method of claim 3 in which measuring data related to a height of said sample at each relevant data point comprises measuring a data point on a first sidewall of the feature then immediately measuring a corresponding data point on the opposite sidewall of the feature.

5. The method of claim 4 further comprising
(a) measuring another data point on a first sidewall of the feature then immediately measuring another corresponding data point on the opposite sidewall of the feature; and
(b) repeating step (a) until all relevant data points on the first sidewall and opposite sidewall have been measured.

6. The method of claim 3 in which determining the number and location of a plurality of relevant data points sufficient to determine at least one dimension of said feature comprises:
using an adaptive algorithm to attempt to select a number of data points at approximately the specified measurement height or depth on opposite sidewalls of the feature so that the data points on each sidewall are in a range from slightly above the specified height to slightly below the specified height.

7. The method of claim 1 in which determining the number and location of a plurality of positioning data points sufficient to locate the feature comprises using an adaptive algorithm to determine from the expected location and dimensions of the feature the number and location of a plurality of positioning data points sufficient to locate the feature.

8. The method of claim 1 in which determining from the expected topography of the feature and the approximate location of said feature the number and location of a plurality of relevant data points sufficient to determine at least one dimension of said feature comprises using an adaptive algorithm to determine from the expected topography of the feature and the approximate location of said feature the number and location of a plurality of relevant data points sufficient to determine at least one dimension of said feature.

9. The method of claim 1 in which determining the number and location of a plurality of positioning data points sufficient to locate the feature comprises locating said positioning data points along a scan line with a data point spacing of 5 to 20 data points per micron.

10. The method of claim 1 in determining the number and location of a plurality of relevant data points sufficient to determine at least one dimension of a feature comprises locating 20 to 40 relevant data points along a scan line.

11. The method of claim 1 in determining the number and location of a plurality of relevant data points sufficient to determine at least one dimension of a feature comprises locating 20 to 40 relevant data points along each of a plurality of scan lines, said scan lines having a line spacing of 5 to 100 scan lines per micron.

12. A method of operating a probe microscope comprising:
positioning a probe tip away from the surface of a sample;
moving the probe tip toward the sample;
determining the initial point of contact between the probe tip and the sample; and
determining the horizontal and vertical position of the probe tip at said initial point of contact.

13. The method of claim 12 in which said probe microscope comprises a probe microscope with a rocking balance beam sensor.

14. The method of claim 13 in which in which determining the initial point of contact between the probe tip and the sample comprises:
measuring the force value experienced by the probe tip as the probe tip is lowered toward the sample; and
performing a statistical analysis of the force value data in order to determine the initial point of contact between probe tip and the substrate.

15. The method of claim 14 is which performing a statistical analysis of the said force value data in order to determine the initial point of contact between probe tip and the sample comprises an F-test comparing the trailing baseline force value data is compared to the leading force value data to determine when the deviation from baseline becomes significant.

16. The method of claim 13 in which determining the initial point of contact between the probe tip and the sample comprises:
measuring the deflection of the balance beam as the probe tip is lowered toward the sample; and
performing a statistical analysis of the balance beam deflection data in order to determine the initial point of contact between probe tip and the sample.

17. The method of claim 16 is which performing a statistical analysis of the said balance beam deflection data in order to determine the initial point of contact between probe tip and the sample comprises an F-test comparing the trailing baseline balance beam deflection data is compared to the leading balance beam deflection data to determine when the deviation from baseline becomes significant.

18. A method of operating a probe microscope comprising:
loading a sample into a probe microscope having a probe tip;
positioning a probe tip away from a location on a feature on the sample, said feature having an expected topography and a known approximate location;
moving the probe tip toward the location on said feature along an angle of approach greater than or equal to a 45 degree angle with respect to the surface of the sample at said location until said probe tip is in contact with the sample at the desired location; and
measuring data related to the horizontal and vertical position of the probe tip with the probe tip in contact with the sample at the desired location.

19. The method of claim 18 further comprising repeating all steps at a plurality of locations in order to obtain an image of the feature.

20. The method of claim 18 in which moving the probe tip toward the location on said feature along an angle of approach greater than or equal to a 45 degree angle with respect to the surface of the sample at said location comprises moving the probe tip toward the location on said feature along an angle substantially perpendicular to the surface of the sample at said location.

21. The method of claim 18 in which measuring data related to a height of the sample with the probe tip in contact with the sample at the desired location comprises measuring the vertical and lateral position of the probe tip with the probe tip in contact with the sample at the desired location.

22. A method of operating a probe microscope comprising:
(a) loading the sample into a probe microscope having a probe tip;
(b) determining the number and location of a plurality of data points on the sample surface;
(c) moving a probe tip toward the surface of the sample at a data point;
(d) measuring data related to the horizontal and vertical position of the probe tip at said data point;
(e) moving the probe tip away from the surface of the sample;
(f) moving the probe tip laterally toward the next data point in a plurality of discrete substeps;
(g) oscillating the probe tip up and down at each substep;
(h) determining whether the probe tip is pushing against the sample surface during said oscillation;
(i) if the probe tip is not pushing against the sample surface during said oscillation, moving the probe tip laterally to the next substep and repeating steps (h) through (j) until the next data point is reached;
(j) if the probe tip is pushing against the sample surface during said oscillation, determining the lateral and vertical position of the probe tip with the probe tip in contact with the sample surface, then moving the probe tip away from the sample surface before moving the probe tip laterally forward to the next substep or the next data point;
(k) moving the probe tip to the surface of a substrate at the next data point and determining the lateral and vertical position of the probe tip at that data point.
(1) repeating steps (e) through (k) until all data points have been measured.

23. The method of claim 22 in which the probe tip is continuously moved in a lateral direction while it is being raised or lowered.

24. The method of claim 22 in which said discrete substeps are 1 to 5 nm.

25. The method of claim 22 in which said discrete substeps are sufficiently small to prevent tip and/or sample damage from a lateral contact between the probe tip and the sample surface.

26. The method of claim 22 in which oscillating the probe tip up and down comprises oscillating the probe tip up and down through a distance of 2 to 10 nm.

27. The method of claim 22 in which moving the probe tip away from the surface of the sample comprises raising the probe tip above the surface to a height substantially less than the maximum height of a feature on the surface of the sample.

28. The method of claim 22 in which moving the probe tip away from the surface of the sample comprises raising the probe tip 10-50 nm from the surface of the sample.

29. The method of claim 22 in which said probe microscope comprises a probe microscope with a rocking balance beam sensor.

30. The method of claim 29 in which determining whether the probe tip is pushing against the sample surface during said oscillation comprises:
measuring the force value experienced by the probe tip as the probe tip oscillated up and down; and
performing a statistical analysis of the force value data in order to determine the initial point of contact between probe tip and the sample surface.

31. The method of claim 30 is which performing a statistical analysis of the said force value data in order to determine the initial point of contact between probe tip and the sample surface comprises an F-test comparing the trailing baseline force value data is compared to the leading force value data to determine when the deviation from baseline becomes significant.

32. The method of claim 29 in which determining whether the probe tip is in contact with the sample surface during said oscillation comprises:
measuring the deflection of the balance beam as the probe tip oscillated up and down; and
performing a statistical analysis of the balance beam deflection data in order to determine the initial point of contact between probe tip and the sample surface.

33. The method of claim 32 is which performing a statistical analysis of the said balance beam deflection data in order to determine the initial point of contact between probe tip and the sample surface comprises an F-test comparing the trailing baseline balance beam deflection data is compared to the leading balance beam deflection data to determine when the deviation from baseline becomes significant.

34. The method of claim 22 in which moving the probe tip away from the sample surface before moving the probe tip laterally forward to the next substep or the next data point comprises:
(a) determining whether the contact between the probe tip and the sample surface is an upward contact such that the initial contact between the probe tip and the sample surface occurs when the probe tip is oscillating up or a downward contact contacting such that the initial contact between the probe tip and the sample surface occurs when the probe tip is oscillating down;
(b) for a downward contact, moving the probe tip laterally back and raising the probe tip higher before moving the probe tip laterally forward to the next substep or the next data point;
(c) for an upward contact, lowering the probe tip and moving the probe tip laterally back then raising the probe tip and determining whether the probe tip comes into contact with the sample surface when it is raised;
(i) if the probe tip comes into contact with the sample surface when it is raised repeat step (c);
(ii) if the probe tip does not come into contact with the sample surface when it is raised, moving the probe tip laterally forward to the next substep or the next data point.

35. A method of operating a probe microscope with a rocking balance beam sensor, said method comprising:
(a) loading the sample into a probe microscope having a probe tip;
(b) determining the number and location of a plurality of data points on the sample surface;
(c) lowering a probe tip to the surface of the sample at a data point;
(d) measuring the deflection of the balance beam as the probe tip is moved in order to determine the initial point of contact between the probe tip and the sample surface.
(e) determining the vertical and horizontal position of the probe tip at said initial point of contact;
(f) raising the probe tip from the surface of the sample;
(g) continuously moving the probe tip laterally toward the next data point while oscillating the probe tip up and down;
(h) measuring the deflection of the balance beam as the probe tip oscillated up and down in order to determine when the probe tip comes into contact with the sample surface;
(i) if the probe tip comes into contact with the sample surface before the next data point is reached, determining the vertical and horizontal position of the probe tip at the point that the probe tip comes into contact with the sample surface;
(j) determining whether the contact is upward or downward;
(k) from expected topography of feature and the direction of contact, determining appropriate direction to move probe tip in order to move the probe tip away from the sample surface and resume lateral movement toward next data point;
(1) repeating steps (g) through (k) until next data point is reached;
(m) once the probe tip is positioned over said next data point, lowering the probe tip to the surface of a substrate at that data point and determining the lateral and vertical position of the probe tip.
(n) repeating steps (f) through (m) until all data points have been measured.

36. The method of claim 35 in which determining appropriate direction to move probe tip in order to move the probe tip away from the sample surface and resume lateral movement toward next data point comprises using an adaptive algorithm to determine appropriate direction to move probe tip in order to move the probe tip away from the sample surface and resume lateral movement toward next data point.

37. A method of lateral force detection when using a probe microscope with a rocking balance beam sensor, said method comprising:
continuously moving the probe tip laterally while modulating the probe tip up and down so that if the probe tip makes contact with the sample surface the up and down modulation of the probe tip will result in friction as the probe tip pushes against the sample surface; and
measuring the deflection of the balance beam in order to determine when the probe tip comes into lateral contact with the sample surface.
